# EUROPEAN PATENT APPLICATION

(11) **EP 3 174 038 A1**
(43) Date of publication of application: **31.05.2017**
(21) Application number: 16199284.7
(22) Date of filing: 17.11.2016
(51) Int. Cl.: G09G 3/20, G11C 19/14, G11C 19/28

(54) **GATE DRIVING CIRCUIT AND DISPLAY DEVICE USING THE SAME**

(30) Priority: 25.11.2015 KR 20150165753
(71) Applicant: LG Display Co., Ltd., Seoul 07336 (KR)
(72) Inventor: KIM, Byungil, 10087 Gimpo-si, Gyeonggi-do (KR)
(74) Representative: Viering, Jentschura & Partner mbB Patent- und Rechtsanwälte

(57) **Abstract**

Provided are a gate driving circuit and a display device using the same, and the gate driving circuit includes a shift register which includes stages. The n-th stage (n is a positive integer) includes an auto reset circuit (31) that receives a first clock (CLKA) and a carry signal (Gout_Pre) received from an (n-1)-th stage, regulates a Q node (Q) to be at a low voltage when the first clock (CLKA) is at a high voltage and the carry signal (Gout_Pre) is at a low voltage, and regulates the Q node (Q) to be at a high voltage when both of the first clock (CLKA) and the carry signal (Gout_Pre) are at a high voltage.

## Description

This application claims the benefit of Korean Patent Application No. 10-2015-0165753 filed on November 25, 2015.

### BACKGROUND OF THE INVENTION

### Field of the Invention

The present disclosure relates to a display device and a method of driving the same. More particularly, the present disclosure relates to a gate driving circuit including a Complementary Metal Oxide Semiconductor (CMOS) transistor element, and a display device using the same.

### Discussion of the Related Art

A flat panel display device includes a Liquid Crystal Display (LCD) device, and an Organic Light Emitting Diode (OLED) display, and the like. A driving circuit of a display device typically includes a pixel array on which an image is displayed, a data driving circuit which supplies data signals to data lines of the pixel array, a gate driving circuit which sequentially supplies to gate lines of the pixel array a gate pulse (or a scan pulse) synchronized with the data signals, a timing controller which controls the data driving circuit and the gate driving circuit, and the like.

Each pixel includes a thin film transistor (TFT) that supplies a voltage of a data line to a pixel electrode in response to a gate pulse supplied through a gate line. The gate pulse swings between a gate high voltage VGH and a gate low voltage VGL. The gate high voltage VGH is set to a voltage higher than a threshold voltage of a TFT formed on a display panel, and the gate low voltage VGL is set to a voltage lower than the threshold voltage of the TFT. The TFTs of pixels are turned on in response to the gate high voltage VGH.

A technology for embedding a gate driving circuit in a display panel together with a pixel array has been employed. A gate driving circuit embedded in a display panel is known as a Gate In Panel (GIP) circuit. The GIP circuit includes a shift register that typically includes a plurality of dependently connected stages. Each stage generates an output in response to a start pulse, and shifts the output in accordance to a shift clock.

The stages of the shift resister include a Q node which charges the gate lines, a Q bar (QB) node which discharges the gate lines, and a switch circuit connected to the Q node and the QB node. The switch circuit discharges the Q node in response to a start pulse or an output from a previous stage so as to cause a voltage of the gate lines to rise, and charges the QB node in response to a reset pulse or an output from a next stage. The switch circuit includes TFTs which are in a structure of Metal Oxide Semiconductor Field Effect Transistor (MOSFET).

The GIP circuit is formed directly on a bezel of a display panel, making it difficult to design a narrow bezel. To embody a narrow bezel, many studies for a simple configuration of the GIP circuit have been made. However, the GIP circuit typically requires certain circuits for stable operation, making it difficult to design a simple configuration of the GIP circuit.

Immediately after a display device embedded with the GIP circuit is power-on, the Q node and the QB node in the GIP circuit are in a random state. In the random state, the GIP circuit may malfunction to generate an abnormal output. For stable operation of the GIP circuit, a reset signal is typically supplied to all stages of the GIP circuit so that an initialization process may be performed with Q = Low and QB = High. To this end, a reset (RST) line for supplying an RST signal to the GIP circuit is typically needed.

In the shift resister of the GIP circuit, multiple stages are connected to each other in cascade. To generate an output signal, each stage receives a first carry signal Gout_Pre for pre-charging the Q node. After generating the output signal, each stage receives a second carry signal Gout_Post for discharging the Q node. To this end, dummy stages, which do not generate an output but supply a carry signal to other stages, are added. For example, the (n+1)-th stage (or an end generator) is connected to the n-th stage (n is a positive integer greater than 2) which outputs the last gate pulse. The (n+1)-th stage does not output a gate pulse, but supplies the second carry signal Gout_Post to the n-th stage.

To reduce the size of a bezel, many studies are now ongoing to optimize the GIP circuit. However, because the GIP circuit typically requires certain circuit elements and signal lines for normal or stable operation, it may be difficult to reduce the size of the GIP circuit as well as the size of the bezel.

### SUMMARY

Accordingly, the present disclosure is directed to a display device and a method of driving the same, which substantially obviate one or more problems due to limitations and disadvantages of the related art.

An advantage of the present disclosure is to provide a display device with a narrow bezel.

Additional advantages and features of embodiments of the present disclosure will be set forth in part in the description which follows and in part will become apparent to those having ordinary skill in the art upon examination of the following or may be learned from practice of the invention. The objectives and other advantages of embodiments of the present invention may be realized and attained by the structure particularly pointed out in the written description and claims hereof as well as the appended drawings.

To achieve these objects and other advantages and in accordance with the purpose of the invention, as embodied and broadly described herein, the gate driving circuit has a shift register that includes a plurality of dependently connected stages.

The n-th stage (n is a positive integer) may include an auto reset circuit that receives a first clock and a carry signal from an (n-1)-th stage, regulates a Q node to be at a low voltage when the first clock is at a high voltage and the carry signal is at a low voltage, and regulates the Q node to be at a high voltage when both of the first clock and the carry signal are at a high voltage.

The n-th stage may further include a latch connected between the Q node and a QB node, and a buffer configured to cause an output voltage to rise when a voltage of the Q node is a high voltage and a second clock is received at a high voltage, and cause the output voltage to fall when a voltage of the QB node is a high voltage. The first clock is synchronized with the carry signal.

A display device according to an embodiment of the present disclosure includes the gate driving circuit.

Various embodiments provide a gate driving circuit having a shift register that comprises a plurality of stages including an n-th stage, wherein n is a positive integer, the n-th stage comprising: an auto reset circuit that is configured to receive a first clock and a carry signal from an (n-1)-th stage, regulate a Q node to be at a low voltage when the first clock is at a high voltage and the carry signal is at a low voltage, and regulate the Q node to be at a high voltage when both of the first clock and the carry signal are at a high voltage; a latch connected between the Q node and a QB node; and a buffer that is configured to cause an output voltage to rise when the voltage of the Q node is a high voltage and a second clock is received at a high voltage, and cause the output voltage to fall when a voltage of the QB node is a high voltage, and wherein the first clock is synchronized with the carry signal.

In one or more embodiments, the auto reset circuit comprises: a first Transmission Gate (TG) configured to receive the first clock and the carry signal, and supply an output signal to the Q node; and a second n-type Metal Oxide Semiconductor Field Effect Transistor (MOSFET) (NMOS) and a second p-type MOSFET (PMOS) which are connected to the first TG.

In one or more embodiments, the first TG comprises: a first NMOS comprising a gate to which the first clock is input, a drain to which the carry signal is input, and a source connected to the Q node, and a first PMOS comprising a gate connected to drains of the second NMOS and the second PMOS, a source to which the carry signal is input, and a drain connected to the Q node.

In one or more embodiments, the second NMOS comprises a gate to which the first clock is input, a drain connected to the gate of the first PMOS, and a source connected to a low potential power line through which the low voltage is supplied.

In one or more embodiments, the second PMOS comprises a gate to which the first clock is input, a drain connected to the gate of the PMOS, and a source connected to a high potential power line.

In one or more embodiments, the latch comprises a first inverter and a second inverter which are connected to each other in a closed-loop feedback circuit, wherein the first inverter comprises: a third NMOS comprising a gate connected to the Q node, a drain connected to the QB node, and a source connected to the low potential power line; and a third PMOS comprising a gate connected to the Q node, a drain connected to the QB node, and a source connected to the high potential power line, and wherein the second inverter comprises: a fourth NMOS comprising a gate connected to the QB node, a drain connected to the Q node, and a source connected to the low potential power line; and a fourth PMOS comprising a gate connected to the QB node, a drain connected to the Q node, and a source connected to the high potential power line.

In one or more embodiments, the buffer comprises: a pull-up transistor configured to supply the second clock to an output node in response to a voltage of the Q node so as to cause the output voltage to rise; and a pull-down transistor configured to discharge the output node in response to a voltage of the QB node so as to cause the output voltage to fall, wherein the pull-up transistor comprises a second TG, and wherein the second clock occurs following after the first clock.

In one or more embodiments, the second TG comprises: a fifth PMOS comprising a gate connected to the QB node, a drain connected to the output node, and a source to which the second clock is input; and a fifth NMOS comprising a gate connected to the Q node, a source connected to the output node, and a drain to which the second clock is input, and wherein the pull-down transistor comprises a sixth NMOS comprising a gate connected to the QB node, a drain connected to the output node, and a source connected to the low potential power line.

In one or more embodiments, in a case where the first clock is charged at a high potential voltage and the carry signal is received at a low electric potential voltage, the voltage of the Q node is reset to a low potential voltage, the voltage of the QB node is reset to a high potential voltage, and, in turn, the second TG is turned off.

Various embodiments provide a display device, comprising: a display panel including data lines, gate lines, a data driving circuit supplying data signals to the data lines, and a gate driving circuit according to one or more embodiments described herein supplying a gate pulse synchronized with the data signals to the gate lines.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is a block diagram illustrating a driving circuit of a display device according to an embodiment of the present disclosure.
FIG. 2 is a diagram illustrating a gate timing control signal and dependently connected stages in a Gate In Panel (GIP) circuit.
FIG. 3 is a circuit diagram illustrating the stage shown in FIG. 2.
FIG. 4 is a waveform diagram illustrating operations of the stage shown in FIG. 3.

### DETAILED DESCRIPTION OF THE ILLUSTRATED EMBODIMENTS

The following description is provided to assist the reader in gaining a comprehensive understanding of the methods, apparatuses, and/or systems described herein. Accordingly, various changes, modifications, and equivalents of the methods, apparatuses, and/or systems described herein will be suggested to those of ordinary skill in the art. Also, descriptions of well-known functions and constructions may be omitted for increased clarity and conciseness.

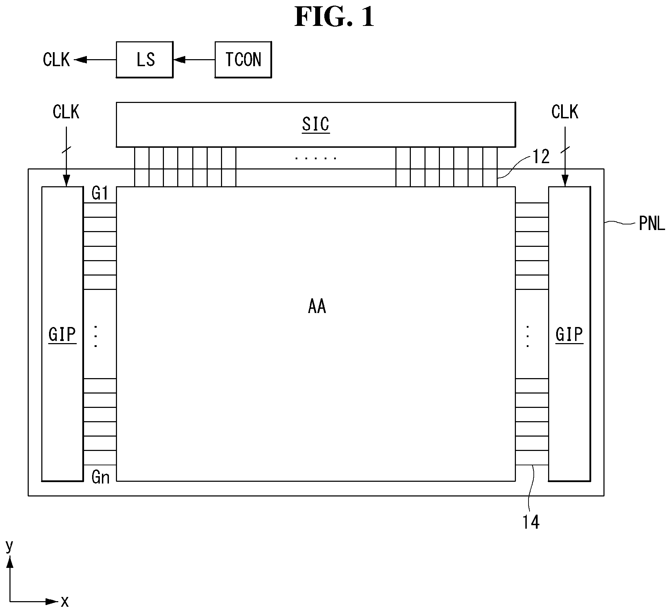

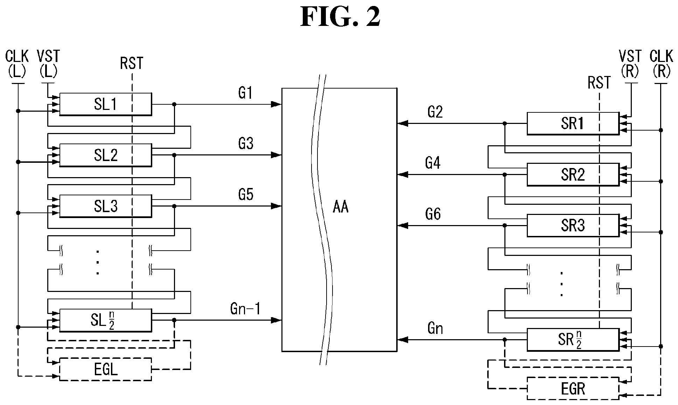

Referring to FIGS. 1 and 2, a display device according to an embodiment of the present disclosure includes a display panel PNL and a display panel driving circuit for writing data of an input image into a pixel array AA of the display panel PNL.

The display panel PNL may be implemented as a display panel of a flat panel display, such as a Liquid Crystal Display (LCD) device and an Organic Light Emitting Diode (OLED) display device, which has a Gate In Panel (GIP) circuit.

The display panel PNL includes data lines 12, gate lines 14 crossing the data lines 12 in an orthogonal manner, and a pixel array AA in which pixels defined by the data lines 12 and the gate lines 14 are arranged in matrix. An input image is displayed on the pixel array AA.

The display panel driving circuit includes a data driving circuit SIC supplying a data voltage to the data lines 12, gate driving circuits LS and GIP sequentially supplying a gate pulse synchronized with the data voltage to the gate lines 14, and a timing controller (TCON).

The timing controller TCON transmits data of an input image received from an external host system to the data driving circuit SIC. The timing controller TCON receives, from the external host system, timing signals which becomes synchronized with the input image, such as a vertical synchronization signal, a horizontal synchronization signal, a data enable signal, a dote clock, and the like. With reference to a received timing signal, the timing controller TCON generates timing control signals for controlling a timing of operating the data driving circuit SIC and gate driving circuits 130 and 140 individually.

The host system may be implemented as one of the following: a TV system, a set-top box, a navigation system, a DVD player, Blu-ray player, a personal computer (PC), a home theater system, and a phone system. The host system transmits pixel data of input images received from various video sources to the timing controller TCON, and transmits a timing signal synchronized with the pixel data to the timing controller TCON.

The data driving circuit SIC is supplied by the timing controller TCON with the data of input images and a data timing control signal. The data driving circuit SIC generates a data voltage by converting the data of input images into a gamma compensation voltage under control of the timing controller TCON, and outputs the data voltage to the data lines 12. The data driving circuit SIC includes a plurality of source driver Integrated Circuit (IC). The source driver ICs may be connected to the data lines 12 by a Chip On Glass (COG) process or a Tape Automated Bonding (TAB) process.

The gate driving circuit includes a level shifter LS and a GIP circuit GIP. A gate timing control signal output from the timing controller TCON is input to the GIP circuit after a voltage level of the gate timing control signal is converted by the level shifter LS. The gate timing control signal includes start pulses VST(L) and VST(R), and shift clocks CLK(L) and CLK(R).

Since a signal input to the level shifter LS is a digital signal, the signal is not capable of driving Thin Film Transistors (TFTs) of the display panel PNL. The level shifter LS shifts a voltage of a gate timing control signal received from the timing controller TCON to convert the gate timing control signal into a signal of a voltage that swings between a gate low voltage VGL and a gate high voltage VGH. The gate high voltage VGH is set as a voltage higher than a threshold voltage of a TFT formed on the display panel PNL, and the gate low voltage VGH is set as a voltage lower than the threshold voltage of the TFT.

The GIP circuit GIP may be formed on an edge of one side of the display panel PNL or on edges of both sides of the display panel PNL. The GIP circuit GIP includes a shift register to which the start pulses VST(L) and VST (R), and the shift clocks CLK(L) and CLK(R) are input. In a case where GIP circuits GIP are formed on both side of the bezel, the start pulses VST (L) and VST(R) and the shift clocks CLK(L) and CLK(R) are respectively supplied to a left GIP circuit GIP and a right GIP circuit GIP, as shown in FIG. 2.

The left GIP circuit GIP includes a first shift register which sequentially supplies a gate pulse to odd-numbered gate lines G1, G3, ..., Gn-1 in the order named. The right GIP circuit GIP includes a second register which is arranged on the right side of the display panel PNL and sequentially supplies a gate pulse to even-numbered gate lines G2, G4, ..., Gn in the order named.

The first shift register includes connected stages SL1 to SLn/2 connected in cascade. The stages SL1 to SLn/2 of the first shift register start to output gate pulses in response to a start pulse VST(L), and shifts the gate pulses in response to a shift clock CLK(L). The gate pulses respectively output from the stages SL1 to SLn/2 are supplied to the odd-numbered gate lines G1, G3, ... Gn-1, and, at the same time, input to a next stage as carry signals Gout-Pre.

The second shift register includes stages SR1 to SRn/2 connected in cascade. The stages SR1 to SRn/2 of the first shift register start to output gate pulses in response to a start pulse VST(R) and shifts the gate pulses in response to a shift clock CLK(R). The gate pulses respectively output from the stages SR1 to SRn/2 are supplied to the even-numbered gate lines G2, G4, ..., Gn, and, at the same time, input to a next stage as carry signals Gout_Pre.

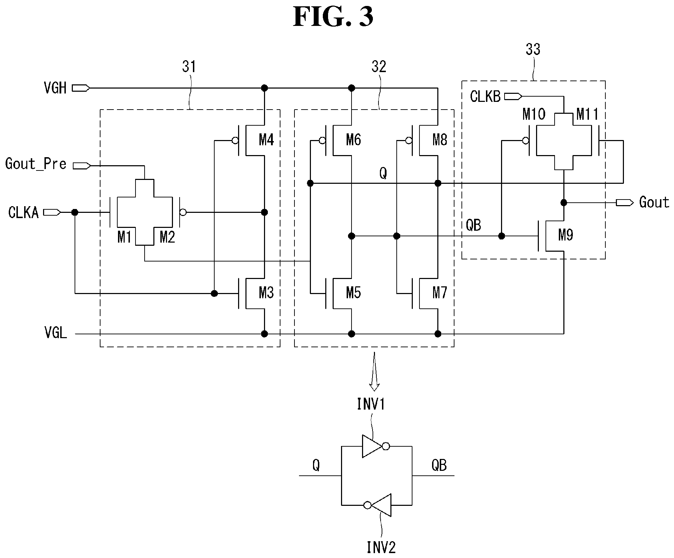

Each stage of the GIP circuit GIP acts as an SR latch which includes a Complementary Metal Oxide Semiconductor (CMOS) transistor, as illustrated in FIG. 3. Each stage controls auto reset by using a carry signal Gout_Pre and a first clock CLKA, and controls a buffer off timing by using the first clock CLKA. As a result, the embodiment of the present disclosure may not need a dummy stage (or an end generator). Accordingly, the aforementioned components are removed from the GIP circuit according to an embodiment of the present disclosure, making it easy to design a narrow bezel.

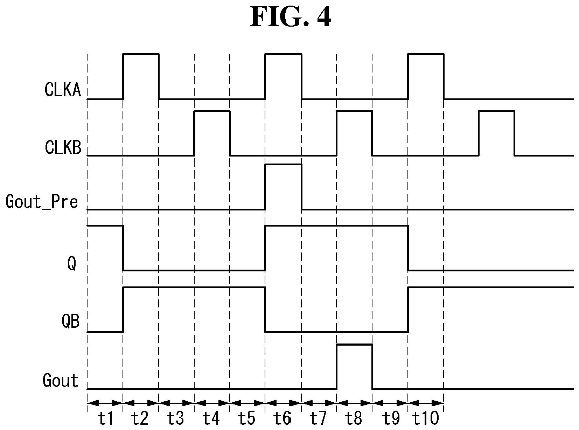

FIG. 3 is a circuit diagram illustrating in details a stage shown in FIG. 2. The circuit shown in FIG. 3 is the n-th stage circuit ("n" is a positive integer). In FIG. 3, M1, M3, M5, M7, M9, and M11 are implemented as n-type Metal Oxide Silicon Field Effect Transistor (MOSFET) (hereinafter, referred to as "NMOS"), and M2, M4, M6, M8, and M10 are implemented as a p-type MOSFET (hereinafter, referred to as "PMOS"). FIG. 4 is a waveform diagram illustrating operations of the stage shown in FIG. 3.

Referring to FIGS. 3 and 4, each stage includes an auto reset circuit 31, a latch 32, and a buffer 33.

A shift clocks CLK(L) or CLK(R), a carry signal/start pulse VST(LS) and VST(R) received from a previous stage, a gate high voltage VGH, and a gate low voltage VGL are input to each stage.

A carry signal input to the n-th stage except for the first stage is an output Gout from the (n-1)-th stage. Not the carry signal Gout_Pre, but the start pulse VST(L) or VST(R) are input to the first stage SL1 or SR1. The shift clock CLK(L) or CLK(R) includes a first clock CLKA, and a second clock CLKB having a phase difference with respect to the first clock CLKA. The second clock CLKB occurs following after the first clock CLKA. The fist clock CLKA becomes synchronized with the carry signal Gout_Pre. In a case where the GIP circuit is formed in one side bezel of a display panel PNL, the second clock CLKB may occur in antiphase of the first clock CLKA.

Each of the auto reset circuit 31 and the buffer 33 includes a Transmission Gate (TG). A TG is a switch element in which an NMOS and a PMOS are connected in parallel to reduce on-resistance RON and which is able to be driven at a voltage over a full range. For example, in a case where VGH = 10V, VGL = 0V, Vth = 1V, and Vgs = 10V are given, if a driving range is 1∼10V, an output voltage range of the NMOS is 1∼10V and an output voltage range of the PMOS is 0∼9V. In this case, Vth denotes a threshold voltage, and Vgs denotes a gate-source voltage. As the NMOS and the PMOS are connected in parallel, the TG may be driven with an output voltage range of 0∼10V, that is, a full range,

The auto reset circuit 31 receives the first clock CLKA and a carry signal Gout_Pre received from the (n-1)-th stage. If CLKA = high and Gout_Pre = low, the auto reset circuit 31 regulates a voltage of Q node Q to be Q = low. Alternatively, if CLKA = high and Gout_Pre = high, the auto reset circuit 31 regulates the voltage of Q node Q to be Q = high. The auto reset circuit 31 includes a first TG M1 or M2, a second NMOS M3, and a second PMOS M4. The first TG includes a first NMOS M1 and a first PMOS M2 connected to each other in parallel. A first clock CLKA and a carry signal Gout_Pre are input to the first TG.

The first NMOS M1 is turned on in response to the first clock CLKA. The first NMOS M1 includes a gate to which the first clock CLKA is input, a drain to which the carry signal Gout_Pre is input, and a source connected to the Q node Q.

The first PMOS M2 is turned on in response to the carry signal Gout_Pre and an output from the second NMOS M3 and the second PMOS M4, wherein the second NMOS M3 and the second PMOS M4 are turned on/off in accordance with the first clock CLKA. The first PMOS M2 includes a gate connected to drains of the second NMOS M3 and the second PMOS M4, a source to which the carry signal Gout_Pre is input, and a drain connected to the Q node.

The second NMOS M3 and the second PMOS M4 operate complementarily in response to the first clock CLKA so as to charge and discharge the gate of the first PMOS M2. When the second NMOS M3 is turned on in response to the first clock CLKA, the second PMOS M4 is turned off. On Contrary, when the second PMOS M4 is turned on, the second NMOS M3 is turned off. The second NMOS M3 includes a gate to which the first clock CLKA is input, a drain connected to the gate of the first PMOS M2, and a source connected to a VGL line (or a low potential power line). The second PMOS M4 includes a gate to which the first clock CLKA is input, a drain connected to the gate of the first PMOS M2, and a source connected to a VGH line (or a high potential power line). The VGL line is supplied with a gate low voltage (VGL). The VGH line is supplied with a gate high voltage (VGH).

An output node of the auto reset circuit 31 is connected to the source of the first NMOS M1, the drain of the first PMOS M2, and the Q node Q. An output signal of the auto reset circuit 31 is supplied to the Q node Q. In response to the output signal, the latch 32 charges or discharges the Q node Q and a QB node QB.

The latch 32 includes two inverters INV1 and INV2, which are connected in a closed-loop feedback circuit, to regulate voltages of the QB node QB in inverse relation to a voltage of the Q node Q. The first inverter INV1 includes a third NMOS M5 and a third PMOS M6. The second inverter INV2 includes a fourth NMOS M7 and a fourth PMOS M8.

The first inverter INV1 supplies an inverse signal of the Q node Q to the QB node QB. The third NMOS M5 includes a gate connected to an output node of the auto reset circuit 31 and to the Q node Q, a drain connected to the QB node QB, and a source connected to the VGL line. The third PMOS M6 includes a gate connected to the output node of the auto reset circuit 31 and to the Q node Q, a drain connected to the QB node QB, and a source connected to the VGH line.

The second inverter INV2 supplies the inverse signal of the QB node QB to the Q node Q. The fourth NMOS M7 includes a gate connected to the QB node QB, a drain connected to the Q node Q, and a source connected to the VGL line. The fourth PMOS M8 includes a gate connected to the QB node QB, a drain connected to the Q node Q, and a source connected to the VGH line.

If Q = high and CLKB = high, the buffer 33 causes an output voltage Gout to rise. Alternatively, if QB = high, the buffer 33 causes an output voltage Gout to fall. The buffer 33 includes a pull-up transistor and a pull-down transistor. In response to a voltage of the Q node Q, the pull-up transistor supplies a second clock CLKB to an output node so as to cause the output voltage Gout to rise. In response to a voltage of the QB node QB, the pull-down transistor discharges the output node so as to cause the output voltage Gout to fall. The pull-up transistor includes a second TG M10 and M11. The pull down transistor includes a sixth NMOS M9. The output voltage is a gate pulse supplied to a gate line.

The second TG includes a fifth NMOS M11 and a fifth PMOS M10 which are connected to each other in parallel. The second clock CLKB is input to the second TG. The fifth PMOS M10 includes a gate connected to the QB node QB, a drain connected to the output node, and a source to which the second clock CLKB is input. The fifth NMOS M11 includes a gate connected to the Q node Q, a source connected to the output node, and a drain to which the second clock CLKB is input.

The sixth NMOS M9 includes a gate connected to the QB node QB, a drain connected to the output node, and a source connected to the VGL line.

The on/off timings of TFTs M1 to M11 in the n-th stage are shown in FIG. 4 and Table 1.

**[Table 1]**

| **TFT** | **t1** | **t2** | **t3** | **t4** | **t5** | **t6** | **t7** | **t8** | **t9** | **1t0** |
|---|---|---|---|---|---|---|---|---|---|---|
| M1 | OFF | ON | OFF | OFF | OFF | ON | OFF | OFF | OFF | ON |
| M2 | OFF | ON | OFF | OFF | OFF | ON | OFF | OFF | OFF | ON |
| M3 | OFF | ON | OFF | OFF | OFF | ON | OFF | OFF | OFF | ON |
| M4 | ON | OFF | ON | ON | ON | OFF | ON | ON | ON | OFF |
| M5 | Abnormal | OFF | OFF | OFF | OFF | ON | ON | ON | ON | OFF |
| M6 | Abnormal | ON | ON | ON | ON | OFF | OFF | OFF | OFF | ON |
| M7 | Abnormal | ON | ON | ON | ON | OFF | OFF | OFF | OFF | ON |
| M8 | Abnormal | OFF | OFF | OFF | OFF | ON | ON | ON | ON | OFF |
| M9 | Abnormal | ON | ON | ON | ON | OFF | OFF | OFF | OFF | ON |
| M11 | Abnormal | OFF | OFF | OFF | OFF | ON | ON | ON | ON | OFF |

Referring to FIGS. 3 and 4, and Tale 1, a period t1 indicates a period of time immediately after a display device is powered on. In the period t1, CLKA = low, CLKB = low, and Gout_Pre = low. Herein, "low" indicates a gate low voltage (VGL), and "high" indicates a gate high voltage (VGH). Thus, in the period t1, each of the Q node Q and the QB node QB is in an abnormal state and thus has a random voltage depending on its previous state. In the period t1, M4 remains in an on-state, and M1 to M3 are in an off-state. In the period t1, M5 to M11 are in a random and abnormal state.

In a period t2, CLKA = high, CLKB = low, and Gout_Pre = low. Thus, M1, M2, and M3 are turned on, and M4 is turned off. At the same time, M6, M7, and M9 are turned on, while M5, M8, and M10 are turned off. In the period t2, resetting is done to be Q = low and QB = high,

In a period t3, CLKA = low, CLKB = low, and Gout_Pre = low. In the period t3, M4, M6 and M7 are in an on-state, and M1 to M3, M8, M5 and M11 are in an off-state. In a period t4, CLKA = low, CLKB = high, and Gout_Pre = high. In the period t4, the TFTs remain in the same states as in the period t3. In a period t5, CLKA = low, CLKB = low, and Gout_Pre = low. Thus, M1, M2, and M3 are turned on, while M4 is turned off. In the period t5, the TFTs remain in the same states as in t4. In the periods t3 to t5, M1 to M3 are in the off-state, M4 is in the on-state. In the periods t3 to t5, M5 to M11 remain in the same state as in the period t2.

In a period t6, CLKA = high, CLKB = low, and Gout_Pre = high. Thus, in the period t6, M1 to M3, M5, M8, M10, and M11 are turned on, and M4, M6, M7, and M9 are turned off. As a result, the Q node Q is charged at the gate high voltage VGH to reach Q = high, and the QB node QB is discharged to reach QB = low.

In a period t7, CLKA = low, CLKB = low, and Gout_Pre = low. In the period t7, M4, M5, M8, M10, and M11 are turned on, and M1 to M3, M6, M7, and M9 are turned off. As a result, in the period t7, Q = high and QB = low, which is the same as in the period t6. In the period t7, CLKA = low, M1 and M2 are turned off, and the latch 32 keeps the Q node Q and the QB node QB in their previous state.

In a period t8, CLKA = low, CLKB = high, and Gout_Pre = low. Thus, in the period t8, M4, M5, M8, M10, and M11 are turned on, and M1 to M3, M6, M7, and M9 are turned off. As a result, CLKB = high is supplied to an output node via the second TG so that an output voltage may rise.

In a period t9, CLKA = low, CLKB = low, and Gout_Pre = low. Thus, the period t9, M4, M5, M8, M10, and M11 are turned on, and M1 to M3, M6, M7, and M9 are turned off. As a result, a voltage of an output node is discharged due to CLKB = low, so that an output voltage may fall.

In a period t10, CLKA = high, CLKB = low, and Gout_Pre = low. In the period t10, the TFTs are in the same states as in the period t2. Thus, M1, M2, and M3 are turned on, while M4 is turned off. At the same time, M6, M7, and M9 are turned on, and M5, M8, M10, and M11 are turned off. In the period t10, resetting is done to be Q = low and QB = high. In the period t10, the second clock CLKB turns off the second TG to control a timing of driving the buffer 33.

As described above, the gate driving circuit according to an embodiment of the present disclosure has an auto reset circuit embedded in each stage and thus does not need an additional reset signal line. In addition, the gate driving circuit is capable of controlling an off timing of a buffer with a first clock, so that an output voltage Vout may be discharged without a dummy stage (or an end generator).

As described above, an embodiment of the present disclosure removes the need of a reset signal line, by using an auto reset circuit which resets a Q node and a QB node with a first clock and a carry signal received from a previous stage. In addition, an embodiment of the present disclosure removes the need of a dummy stage (or an end generator), by controlling a buffer off timing with a first clock. As a result, an embodiment of the present disclosure makes a simple configuration of a GIP circuit to embody a narrow bezel of a display device.

## Claims

1. A gate driving circuit (LS, GIP) having a shift register that comprises a plurality of stages including an n-th stage, wherein n is a positive integer, the n-th stage comprising:
an auto reset circuit (31) that is configured to receive a first clock (CLKA) and a carry signal (Gout_Pre) from an (n-1)-th stage, regulate a Q node (Q) to be at a low voltage when the first clock (CLKA) is at a high voltage and the carry signal (Gout_Pre) is at a low voltage, and regulate the Q node (Q) to be at a high voltage when both of the first clock (CLKA) and the carry signal (Gout_Pre) are at a high voltage;
a latch (32) connected between the Q node (Q) and a QB node (QB); and
a buffer (33) that is configured to cause an output voltage (Gout) to rise when the voltage of the Q node (Q) is a high voltage and a second clock (CLKB) is received at a high voltage, and cause the output voltage (Gout) to fall when a voltage of the QB node (QB) is a high voltage, and
wherein the first clock (CLKA) is synchronized with the carry signal (Gout_Pre).

2. The gate driving circuit (LS, GIP) of claim 1, wherein the auto reset circuit (31) comprises:
a first Transmission Gate configured to receive the first clock (CLKA) and the carry signal (Gout_Pre), and supply an output signal to the Q node (Q); and
a second n-type Metal Oxide Semiconductor Field Effect Transistor (M3) and a second p-type Metal Oxide Semiconductor Field Effect Transistor (M4) which are connected to the first Transmission Gate.

3. The gate driving circuit (LS, GIP) of claim 2, wherein the first Transmission Gate comprises:
a first n-type Metal Oxide Semiconductor Field Effect Transistor (M1)comprising a gate to which the first clock (CLKA) is input, a drain to which the carry signal (Gout_Pre) is input, and a source connected to the Q node (Q), and
a first p-type Metal Oxide Semiconductor Field Effect Transistor (M2)comprising a gate connected to drains of the second n-type Metal Oxide Semiconductor Field Effect Transistor (M3) and the second p-type Metal Oxide Semiconductor Field Effect Transistor (M4), a source to which the carry signal (Gout_Pre) is input, and a drain connected to the Q node (Q).

4. The gate driving circuit (LS, GIP) of claim 3, wherein the second n-type Metal Oxide Semiconductor Field Effect Transistor (M3) comprises a gate to which the first clock (CLKA) is input, a drain connected to the gate of the first p-type Metal Oxide Semiconductor Field Effect Transistor (M2), and a source connected to a low potential power line through which the low voltage is supplied.

5. The gate driving circuit (LS, GIP) of claim 4, wherein the second p-type Metal Oxide Semiconductor Field Effect Transistor (M4) comprises a gate to which the first clock (CLKA) is input, a drain connected to the gate of the first p-type Metal Oxide Semiconductor Field Effect Transistor (M2), and a source connected to a high potential power line.

6. The gate driving circuit (LS, GIP) of claim 5,
wherein the latch (32) comprises a first inverter (INV1) and a second inverter (INV2) which are connected to each other in a closed-loop feedback circuit,
wherein the first inverter (INV1) comprises:
a third n-type Metal Oxide Semiconductor Field Effect Transistor (M5) comprising a gate connected to the Q node (Q), a drain connected to the QB node (QB), and a source connected to the low potential power line; and
a third p-type Metal Oxide Semiconductor Field Effect Transistor (M6) comprising a gate connected to the Q node (Q), a drain connected to the QB node (QB), and a source connected to the high potential power line, and
wherein the second inverter (INV2) comprises:
a fourth n-type Metal Oxide Semiconductor Field Effect Transistor (M7) comprising a gate connected to the QB node (QB), a drain connected to the Q node (Q), and a source connected to the low potential power line; and
a fourth p-type Metal Oxide Semiconductor Field Effect Transistor (M8) comprising a gate connected to the QB node (QB), a drain connected to the Q node (Q), and a source connected to the high potential power line.

7. The gate driving circuit (LS, GIP) of claim 6,
wherein the buffer (33) comprises:
a pull-up transistor configured to supply the second clock (CLKB) to an output node in response to a voltage of the Q node (Q) so as to cause the output voltage (Gout) to rise; and
a pull-down transistor configured to discharge the output node in response to a voltage of the QB node (QB) so as to cause the output voltage (Gout) to fall, wherein the pull-up transistor comprises a second Transmission Gate, and
wherein the second clock (CLKB) occurs following after the first clock (CLKA).

8. The gate driving circuit (LS, GIP) of claim 7,
wherein the second Transmission Gate comprises:
a fifth p-type Metal Oxide Semiconductor Field Effect Transistor (M10) comprising a gate connected to the QB node (QB), a drain connected to the output node, and a source to which the second clock (CLKB) is input; and
a fifth n-type Metal Oxide Semiconductor Field Effect Transistor (M11) comprising a gate connected to the Q node (Q), a source connected to the output node, and a drain to which the second clock (CLKB) is input, and
wherein the pull-down transistor comprises a sixth n-type Metal Oxide Semiconductor Field Effect Transistor (M9) comprising a gate connected to the QB node (QB), a drain connected to the output node, and a source connected to the low potential power line.

9. The gate driving circuit (LS, GIP) of claim 8, wherein, in a case where the first clock (CLKA) is charged at a high potential voltage and the carry signal (Gout_Pre) is received at a low electric potential voltage, the voltage of the Q node (Q) is reset to a low potential voltage, the voltage of the QB node (QB) is reset to a high potential voltage, and, in turn, the second Transmission Gate is turned off.

10. A display device comprising:
a display panel including data lines (12), gate lines (14), a data driving circuit (SIC) that is configured to supply data signals to the data lines (12) and a gate driving circuit (LS, GIP) according to any one of claims 1 to 9 that is configured to supply a gate pulse synchronized with the data signals to the gate lines (14).
